# EUROPEAN PATENT APPLICATION

(11) **EP 4 723 848 A1**
(43) Date of publication of application: **08.04.2026**
(21) Application number: 24815273.8
(22) Date of filing: 20.05.2024
(51) Int. Cl.: H10K 39/10, H10K 30/40, H10K 30/88

(54) **METHOD FOR PRODUCING PHOTOELECTRIC CONVERSION ELEMENT, AND PHOTOELECTRIC CONVERSION ELEMENT**

(30) Priority: 02.06.2023 JP 2023091536
(71) Applicant: Panasonic Intellectual Property Management Co., Ltd., Kadoma-shi, Osaka 571-0057 (JP)
(72) Inventor: UCHIDA, Ryusuke, Kadoma-shi, Osaka 571-0057 (JP)
(74) Representative: Grünecker Patent- und Rechtsanwälte PartG mbB
(86) International application number: PCT/JP2024/018543
(87) International publication number: WO 2024/247789

(57) **Abstract**

A photoelectric conversion element manufacturing method according to the present disclosure includes:
(A) forming a first electrode layer on a gas barrier layer;
(B) removing a part of the first electrode layer using a pulsed laser to form a through hole penetrating the first electrode layer and including a plurality of holes partially overlapping each other;
(C) forming a light absorbing layer on the first electrode layer and on the gas barrier layer exposed by the through hole; and
(D) forming a second electrode layer on the light absorbing layer.

## Description

### Technical Field

The present disclosure relates to a photoelectric conversion element manufacturing method and a photoelectric conversion element.

### Background Art

In recent years, solar cells have become increasingly important as a renewable energy source. Solar cells include a photoelectric conversion element that converts light energy into electrical energy. In addition, research and development of a flexible photoelectric conversion element in which a photoelectric conversion element is formed on a flexible substrate have been actively carried out, as described in non-patent literature 1.

### Citation List

### Non-Patent Literature

PTL 1: Japanese Unexamined Patent Application Publication No. 2022-34875
PTL 2: Japanese Patent No. 5734437
NPL 1: H. S. Jung et al. Joule 3, 1850 (2019)
NPL 2: J. Dagar et al. Nano Research 11 (5), 2669 (2018)

### Summary of Invention

### Technical Problem

The present disclosure provides a method of manufacturing a photoelectric conversion element that achieves both high durability and a uniform appearance.

### Solution to Problem

The present disclosure provides a photoelectric conversion element manufacturing method including:
(A) forming a first electrode layer on a gas barrier layer;
(B) removing a part of the first electrode layer using a pulsed laser to form a through hole penetrating the first electrode layer and including a plurality of holes partially overlapping each other;
(C) forming a light absorbing layer on the first electrode layer and on the gas barrier layer exposed by the through hole; and
(D) forming a second electrode layer on the light absorbing layer.

### Advantageous Effects of Invention

The present disclosure provides a method of manufacturing a photoelectric conversion element that achieves both high durability and a uniform appearance.

### Brief Description of Drawings

[Fig. 1] Fig. 1 is a schematic cross-sectional view illustrating a photoelectric conversion element manufacturing method according to a first embodiment of the present disclosure.
[Fig. 2] Fig. 2 is a view for explaining a method of obtaining an average value Lₐᵥₑ of line width L of a through hole.
[Fig. 3] Fig. 3 is a view for explaining the relationship among the overlap of pulses radiated to continuously form circular through holes, a minimum value Lₘᵢₙ of the line width L of a linear through hole formed, and a ratio Lₘᵢₙ/Lₐᵥₑ.
[Fig. 4A] Fig. 4A is a schematic view illustrating a linear through hole with a ratio Lₘᵢₙ/Lₐᵥₑ of 0.57, formed by continuously forming circular through holes each formed by irradiation with one pulse.
[Fig. 4B] Fig. 4B is a schematic view illustrating a linear through hole with a ratio Lₘᵢₙ/Lₐᵥₑ of 0.91, formed by continuously forming circular through holes each formed by irradiation with one pulse.
[Fig. 5] Fig. 5 is a schematic cross-sectional view illustrating an example of a photoelectric conversion element according to the first embodiment of the present disclosure.
[Fig. 6] Fig. 6 is a schematic cross-sectional view illustrating a modification of the photoelectric conversion element according to the first embodiment of the present disclosure.
[Fig. 7] Fig. 7 is a schematic cross-sectional view illustrating a photoelectric conversion module as a photoelectric conversion element according to a second embodiment of the present disclosure.
[Fig. 8A] Fig. 8A is a scanning electron microscope (SEM) image of a partial cross section of the photoelectric conversion element according to Example 1.
[Fig. 8B] Fig. 8B is a partial top SEM image obtained by capturing a part of a first electrode layer in which a through hole is formed from the top in Example 1.
[Fig. 8C] Fig. 8C is a cross-sectional SEM image of the photoelectric conversion element according to Example 1.

### Description of Embodiments

### [Underlying Knowledge Forming Basis of the Present Disclosure]

When a flexible substrate is used for a photoelectric conversion element, a base material containing an organic material, such as a transparent organic material film, is used as a substrate in consideration of optical transparency. In order to improve the durability of the photoelectric conversion element, it is necessary to prevent the intrusion of a gas into the element. In particular, in organic solar cells and perovskite solar cells, it is necessary to prevent the intrusion of water vapor. The term "perovskite solar cell" refers to a solar cell containing a perovskite compound.

Thus, in order to ensure the gas barrier property of a substrate, a method of forming a thin gas barrier layer on a base material containing an organic material such as an organic film is generally used, as disclosed in PTL 1. Meanwhile, when fabricating a photoelectric conversion element, electrodes are generally patterned to prevent short-circuit and leakage currents, or to correctly drive the photoelectric conversion element such as when fabricating an integrated module in which a plurality of cells are integrated. Therefore, when a base material containing an organic material and provided with a gas barrier layer is used as a substrate, it is necessary to form electrodes patterned on the gas barrier layer when fabricating a photoelectric conversion element.

As methods of forming patterned electrodes, there may be mentioned a method in which a mask is used and a method in which etching is performed. However, with these methods, the width of an electrode removal part for patterning cannot be reduced, resulting in non-uniform appearance. A laser scribing method in which patterned electrodes are formed by removing the electrodes using a nanosecond pulsed laser is also known, as disclosed in PTL 2, NPL 1, and NPL 2. However, when the laser scribing method is used to pattern electrodes provided on a gas barrier layer, not only the electrodes but also the gas barrier layer may be removed or damaged, reducing the durability of the element.

In order to obtain a photoelectric conversion element that achieves both high durability and a uniform appearance, the inventor has made diligent studies and created the photoelectric conversion element manufacturing method according to the present disclosure and the photoelectric conversion element according to the present disclosure.

### [Embodiments of the Present Disclosure]

Embodiments of the present disclosure will be described below with reference to the drawings.

### (First Embodiment)

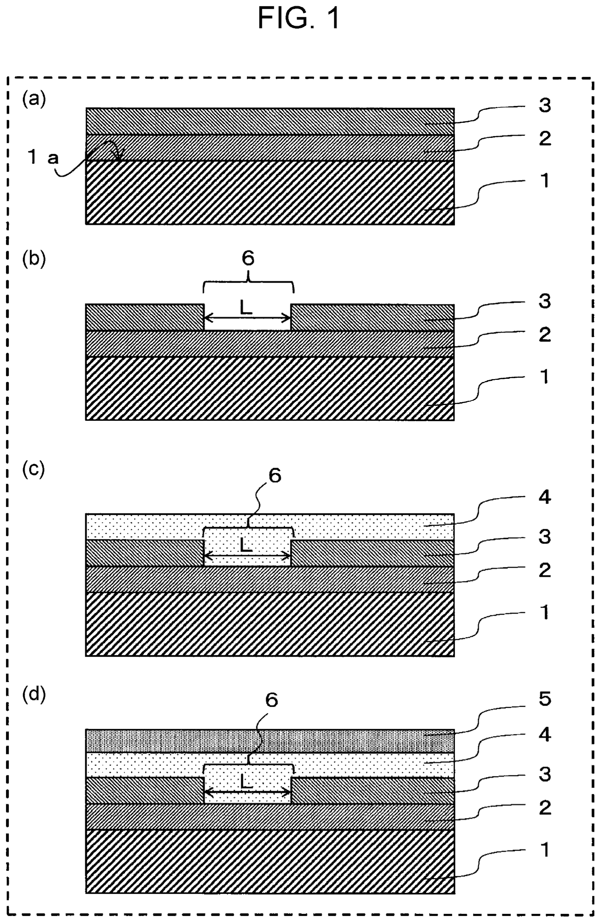

Fig. 1 is a schematic cross-sectional view illustrating a photoelectric conversion element manufacturing method according to a first embodiment of the present disclosure. The photoelectric conversion element manufacturing method according to the first embodiment includes:
(A) forming a first electrode layer 3 on a gas barrier layer 2, the gas barrier layer 2 being in a "base material with a gas barrier layer" including a base material 1 containing an organic material and a gas barrier layer 2 provided on a first principal surface 1a of the base material 1 (see Fig. 1(a));
(B) removing a part of the first electrode layer 3 using a pulsed laser having a pulse width of less than 1 ns to form a linear through hole 6 that penetrates the first electrode layer 3 (see Fig. 1(b));
(C) forming a light absorbing layer 4 on the first electrode layer 3 and on the gas barrier layer 2 exposed by the through hole 6 (see Fig. 1(c)); and
(D) forming a second electrode layer 5 on the light absorbing layer 4 (see Fig. 1(d)).

An average value Lₐᵥₑ of line width L of the through hole 6 is preferably less than 100 µm, more preferably 50 µm or less. Here, the average value Lₐᵥₑ of the line width L of the through hole 6 is determined using an image (for example, an SEM image) obtained by capturing the first electrode layer 3, in which the through hole 6 is formed, from the top. Specifically, in the image obtained by capturing the first electrode layer 3, in which the through hole 6 is formed, from the top, the area of a portion from which the first electrode layer 3 has been removed (i.e., the portion of the linear through hole 6) and the length of such a portion (i.e., the length along the direction in which the linear through hole 6 extends) are determined. Next, a rectangle having the same area as the determined area and the same length as the determined length of the linear through hole 6 is determined. The width (the length of the short side) of the rectangle is defined as the average value Lₐᵥₑ of the line width L of the through hole 6.

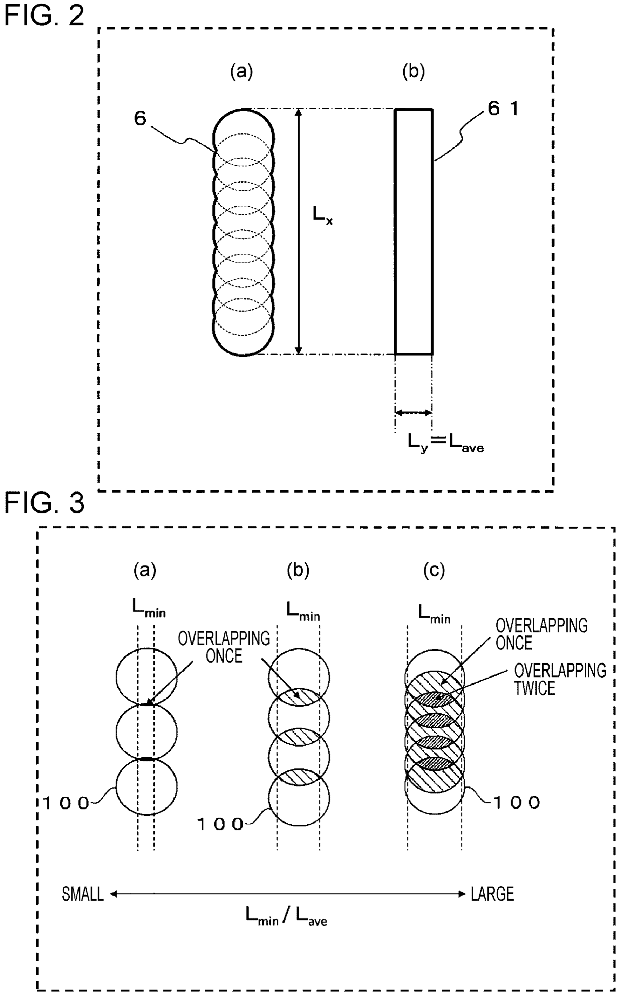

Fig. 2 is a view for explaining a method of determining the average value Lₐᵥₑ of the line width L of the through hole 6. Fig. 2(a) is a schematic view schematically illustrating the shape of the through hole 6 when viewed from the top surface of the first electrode layer 3, in which the through hole 6 is formed. Hereinafter, the shape of the through hole 6 viewed from the top surface of the first electrode layer 3, in which the through hole 6 is formed, will be referred to as "the shape of the through hole 6". As discussed above, the through hole 6 is formed by removing a part of the first electrode layer 3 using a pulsed laser having a pulse width of less than 1 ns. Thus, the shape of the through hole 6 is as a whole in a linear shape in which a plurality of circular holes are disposed side by side in one direction so as to overlap each other, as illustrated in Fig. 2(a). A length Lx of the through hole 6 in the direction in which the linear through hole 6 extends and the area of the through hole 6 are determined. Lx and the area of the through hole 6 can be calculated, for example, by analyzing the SEM image of the through hole 6. Next, a rectangle 61 having the same area as the area of the through hole 6 and the same length Lx as the length Lx of the linear through hole 6, as illustrated in Fig. 2(b), is determined. A width Ly of the rectangle 61 is specified as the average value Lₐᵥₑ of the line width L of the through hole 6.

With the manufacturing method according to the first embodiment, the through hole 6 is formed using a pulsed laser having a pulse width of less than 1 ns. Thus, an electrode removal part for patterning of the first electrode layer 3 can be formed to have a small width such that the average value Lₐᵥₑ of the line width L of the through hole 6 is preferably less than 100 µm, more preferably 50 µm or less. Consequently, in the photoelectric conversion element obtained by the manufacturing method according to the first embodiment, a portion from which the first electrode layer 3 has been removed by patterning is thin and therefore inconspicuous. Thus, there is less likely to be a difference in appearance between a portion from which the first electrode layer 3 has not been removed and the portion from which the first electrode layer 3 has been removed, and the photoelectric conversion element can have a uniform appearance. Furthermore, the through hole 6 is formed using a pulsed laser having a pulse width of less than 1 ns, which can reduce the damage to the gas barrier layer caused by the irradiation with the pulsed laser. Thus, the gas barrier layer 2 can maintain a good gas barrier property, and the gas barrier layer 2 effectively suppresses the intrusion of a gas such as water vapor into the photoelectric conversion element. Consequently, the photoelectric conversion element obtained by the manufacturing method according to the first embodiment can have high durability. In addition, in the manufacturing method according to the first embodiment, a base material having an organic material is used, and thus a flexible photoelectric conversion element is obtained.

In the manufacturing method according to the first embodiment, a glass base material or a metal base material may be used. In the manufacturing method according to the first embodiment, a second photoelectric conversion element may be further formed above the base material, and the gas barrier layer may be disposed above the second photoelectric conversion element, constituting a tandem structure.

As described above, with the manufacturing method according to the first embodiment, it is possible to manufacture a flexible photoelectric conversion element that achieves both high durability and a uniform appearance.

In the above (B) of the manufacturing method according to the first embodiment, it is desirable to form a through hole 6 with a continuously varying line width L by radiating a pulsed laser onto the first electrode layer 3 such that a ratio Lₘᵢₙ/Lₐᵥₑ of the minimum value Lₘᵢₙ of the line width L to the average value Lₐᵥₑ of the line width L satisfies 0.57 < Lₘᵢₙ/Lₐᵥₑ < 0.91. The minimum value Lₘᵢₙ of the line width L is determined using an image (for example, an SEM image) obtained by capturing the first electrode layer 3, in which the through hole 6 is formed, from the top. Specifically, in the image obtained by capturing the first electrode layer 3, in which the through hole 6 is formed, from the top, the smallest value of the line width of a portion from which the first electrode layer 3 has been removed (i.e., the portion of the linear through hole 6) is specified, and defined as the minimum value Lₘᵢₙ of the line width L.

In processing with a pulsed laser, a circular through hole is usually formed for each pulse. In order to form a linear through hole in the first electrode layer using a pulsed laser, circular through holes formed for each pulse are continuously formed. In that event, the damage to the gas barrier layer 2 caused by the irradiation with the pulsed laser can be reduced by reducing the overlap between pulses.

Fig. 3 is a view for explaining the relationship among the overlap of pulses radiated to continuously form circular through holes, the minimum value Lₘᵢₙ of the line width L of the linear through hole 6 formed, and the ratio Lₘᵢₙ/Lₐᵥₑ. Fig. 3 illustrates pulses 100 radiated to form the through hole 6. In Fig. 3, the overlapping portion of the pulses 100 is hatched. The shape of the pulses 100 substantially coincides with the shape of the portion from which the first electrode layer 3 is removed by the irradiation with the pulses 100. In the example illustrated in Fig. 3(a), the effect of the arcs remains in the outer shape of the linear through hole 6 formed, but the circular through holes formed for each pulse are connected to each other to achieve a linear shape as a whole, and the overlap of the pulses 100 can be reduced. In this case, the minimum value Lₘᵢₙ of the through hole 6 formed is small, the ratio Lₘᵢₙ/Lₐᵥₑ is also small, and thus the damage to the gas barrier layer 2 caused by the irradiation with the pulsed laser can be greatly reduced, although the effect of the arcs remains in the outer shape of the linear through hole 6 formed. In the example illustrated in Fig. 3(b), the overlap of the pulses 100 for forming the through hole is slightly larger than that in the example in Fig. 3(a), and the minimum value Lₘᵢₙ and the ratio Lₘᵢₙ/Lₐᵥₑ are also larger than those in the example in Fig. 3(a). However, in the example illustrated in Fig. 3(b), the effect of the arcs remaining in the outer shape of the linear through hole 6 formed is reduced, and the outer shape of the linear through hole 6 formed can be brought closer to a straight line. In the example illustrated in Fig. 3(b), in the overlapping portion of the pulses 100, the pulses 100 overlap each other once, that is, the number of pulses radiated to the overlapping portion is two, and therefore the damage to the gas barrier layer 2 caused by the pulsed laser can be sufficiently suppressed. In the example illustrated in Fig. 3(c), the overlap of the pulses 100 for forming the through hole is larger than that in the example in Fig. 3(b), and the minimum value Lₘᵢₙ and the ratio Lₘᵢₙ/Lₐᵥₑ are also larger than those in the example in Fig. 3(b). However, in the example illustrated in Fig. 3 (c), the effect of the arcs remaining in the outer shape of the linear through hole 6 formed is significantly reduced, and the outer shape of the linear through hole 6 formed can be brought even closer to a straight line. In addition, since there are some portions in which the pulses 100 overlap each other twice, the damage to the gas barrier layer 2 caused by the pulsed laser is greater than that in the examples in Fig. 3(a) and Fig. 3(b), but the damage to the gas barrier layer 2 can be sufficiently reduced compared to the conventional method in which a pulsed laser is used.

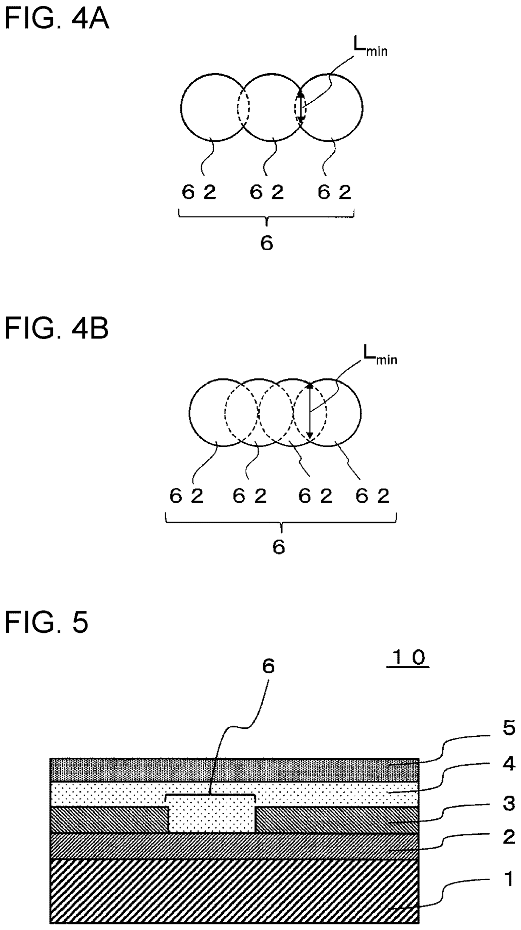

In the above (B) of the manufacturing method according to the first embodiment, by radiating a pulsed laser onto the first electrode layer 3 such that the ratio Lₘᵢₙ/Lₐᵥₑ satisfies 0.57 < Lₘᵢₙ/Lₐᵥₑ < 0.91, a linear through hole can be formed while further reducing the damage to the gas barrier layer 2 caused by the pulsed laser. Fig. 4A is a schematic view illustrating the linear through hole 6 with a ratio Lₘᵢₙ/Lₐᵥₑ of 0.57, formed by continuously forming circular through holes 62 each formed by irradiation with one pulse. Fig. 4B is a schematic view illustrating the linear through hole 6 with a ratio Lₘᵢₙ/Lₐᵥₑ of 0.91, formed by continuously forming circular through holes 62 each formed by irradiation with one pulse. By making the ratio Lₘᵢₙ/Lₐᵥₑ greater than 0.57, that is, by making the overlap of the through holes 62 larger than that illustrated in Fig. 4A, the circular through holes 62 each formed by irradiation with one pulse can be more reliably formed in a continuous linear shape, thereby efficiently forming the linear through hole 6 while reducing the damage to the gas barrier layer 2. In the state illustrated in Fig. 4B, in which the ratio Lₘᵢₙ/Lₐᵥₑ of the linear through hole 6 is 0.91, the overlap of the pulses is maximized within the range in which there is no portion in which the pulses overlap each other twice or more (i.e., such that no region is irradiated with three or more pulses). That is, by reducing the ratio Lₘᵢₙ/Lₐᵥₑ to be less than 0.91, it is possible to form a linear through hole 6 with an excellent appearance while suppressing the damage to the gas barrier layer 2 caused by the pulsed laser.

Fig. 5 is a schematic cross-sectional view illustrating an example of the photoelectric conversion element according to the first embodiment of the present disclosure. A photoelectric conversion element 10 according to the first embodiment illustrated in Fig. 5 may be manufactured, for example, by the photoelectric conversion element manufacturing method according to the first embodiment discussed above. The photoelectric conversion element 10 according to the first embodiment includes: a base material 1 containing an organic material 1; a gas barrier layer 2 disposed on the base material 1; a first electrode layer 3 disposed on the gas barrier layer 2 and having a linear through hole 6; a light absorbing layer 4 disposed on the first electrode layer 3 and the gas barrier layer 2 exposed by the through hole 6; and a second electrode layer 5 disposed on the light absorbing layer 4. An average value Lₐᵥₑ of line width L of the through hole 6 is preferably less than 100 µm, more preferably 50 µm or less. Furthermore, in the photoelectric conversion element 10 according to the first embodiment, the water vapor transmission rate of a stacked body formed from the base material 1, the gas barrier layer 2, and the first electrode layer 3 having the through hole 6 as measured under the conditions of a temperature of 85°C and a relative humidity of 85% is less than 1 × 10° (g/m²/day).

The water vapor transmission rate of the stacked body is specifically measured using a calcium corrosion method. A sample for evaluation is fabricated as follows. The stacked body, which is to be measured, is installed on a glass substrate on which a metal calcium thin film and an electrode are formed, so as to cover the metal calcium. The stacked body and the glass substrate are bonded to each other by disposing butyl rubber between the stacked body and the glass substrate along the outer periphery of the stacked body. The water vapor transmission rate of the sample fabricated in this way is measured by leaving the sample to stand under the conditions of 85°C and a relative humidity of 85% for a certain period of time and measuring the variation in the resistance value of the metal calcium thin film.

Hereinafter, the through hole 6 provided in the first electrode layer 3 will be referred to as a first through hole 6, in order to be distinguished from a through hole that may be provided in the light absorbing layer 4 in a second embodiment to be discussed below. Meanwhile, the through hole provided in the light absorbing layer 4 will be referred to as a second through hole.

In the photoelectric conversion element 10 according to the first embodiment, the average value Lₐᵥₑ of the line width L of the first through hole 6 provided in the first electrode layer 3 is preferably less than 100 µm, more preferably 50 µm or less. Thus, the photoelectric conversion element 10 can have a uniform appearance, since the width of the electrode removal part for patterning of the first electrode layer 3 can be reduced. Furthermore, the photoelectric conversion element 10 has a low water vapor transmission rate of less than 1 × 10⁰ (g/m²/day) in the above stacked body, and thus has an excellent gas barrier property due to the gas barrier layer. Thus, the photoelectric conversion element 10 can prevent gases such as water vapor from intruding into the element, and thus has high durability as well. In this manner, the photoelectric conversion element 10 according to the first embodiment is a flexible photoelectric conversion element that achieves both high durability and a uniform appearance.

In order to improve durability better, the water vapor transmission rate of the above stacked body may be 1 × 10⁻¹ (g/m²/day) or less, or may be 1 × 10⁻² (g/m²/day) or less.

The constituent elements of the photoelectric conversion element 10 will be specifically described below.

### <Base Material>

The base material 1 containing an organic material plays the role of holding the layers of the photoelectric conversion element 10. In addition, in order to achieve a lightweight and flexible photoelectric conversion element 10, the base material 1 is made of an organic film, for example. When the base material 1 is on the light incident side, the base material 1 is made of a translucent material.

Examples of the material of the organic film forming the base material 1 include polyester, polyamide, polyimide, polyamide-imide, polystyrene, polyolefin, polycarbonate, polysulfone, polyurethane, polyarylate, polyether-ether-ketone, polyether sulfone, acrylic resins, fluoropolymer resins, cellulose acetate resins, and cycloolefin polymers. These include polyethylene terephthalate (PET), polybutylene terephthalate (PBT), polyethylene naphthalate (PEN), polypropylene (PP), polyphenylene sulfide (PPS), polyetherimide (PEI), and polytetrafluoroethylene (PTFE).

### <Gas Barrier Layer>

The gas barrier layer 2 plays the role of preventing the intrusion of gases into the light absorbing layer 4 from the outside. In particular, the gas barrier layer 2 plays the role of preventing the intrusion of water vapor. The gas barrier layer 2 is generally composed of an inorganic oxide, but this is not limiting and the gas barrier layer 2 may be composed of a substance with a high water vapor barrier property. The water vapor transmission rate WVTR of the gas barrier layer 2 is less than 1 × 10⁰ (g/m²/day), for example, and may be 1 × 10⁻¹ (g/m²/day) or less, and may be 1 × 10⁻² (g/m²/day) or less. The WVTR here is a value measured under the conditions of a temperature of 85°C and a relative humidity of 85%.

### <First Electrode Layer>

The first electrode layer 3 is electrically conductive. In addition, the first electrode layer 3 may be translucent. For example, the first electrode layer 3 can be formed using a metal oxide and/or a metal nitride that transmits light in the visible region to the near-infrared region and is electrically conductive. Examples of such a material include titanium oxide doped with at least one species selected from the group consisting of lithium, magnesium, niobium, and fluorine, gallium oxide doped with at least one species selected from the group consisting of tin and silicon, gallium nitride doped with at least one species selected from the group consisting of silicon and oxygen, tin oxide doped with at least one species selected from the group consisting of antimony and fluorine, zinc oxide doped with at least one species selected from the group consisting of boron, aluminum, gallium, and indium, indium-tin composite oxide, and compounds of these. The thickness of the first electrode layer 3 is 1 nm or more and 1000 nm or less, for example.

The first electrode layer 3 is provided with a linear first through hole 6. With the provision of the first through hole 6, the first electrode layer 3 is composed of a plurality of portions electrically separated in the plane, for example. The first through hole 6 penetrates only the first electrode layer 3 and does not penetrate the gas barrier layer 2.

As discussed above, the first through hole 6 provided in the first electrode layer 3 is formed by removing a part of the first electrode layer 3 using a pulsed laser in the above (B) of the manufacturing method according to the first embodiment. The pulsed laser has a pulse width of less than 1 ns. Since the pulse width is small, thermal damage caused by laser processing can be applied locally to the first electrode layer 3, and only the first electrode layer 3 can be removed without affecting the gas barrier layer 2 on the lower side. The wavelength of the pulsed laser can be 1064 nm, 532 nm, or 355 nm, but these are not particularly limiting and the wavelength of the pulsed laser may be any wavelength at which the first electrode layer 3 can be processed.

As discussed above, the average value Lₐᵥₑ of the line width L of the first through hole 6 formed in the first electrode layer 3 is preferably less than 100 µm, more preferably 50 µm or less. In processing with a pulsed laser, a circular through hole is usually formed for each pulse. In order to form the first through hole 6 that electrically separates the first electrode layer 3 into a plurality of portions, such circular through holes are continuously formed. In that event, the damage to the gas barrier layer 2 can be reduced by reducing the overlap between pulses. Therefore, it is desirable that the line width of the through hole 6 should vary continuously. It is desirable that the ratio Lₘᵢₙ/Lₐᵥₑ of the minimum value Lₘᵢₙ of the line width L to the average value Lₐᵥₑ of the line width L should satisfy 0.57 < Lₘᵢₙ/Lₐᵥₑ < 0.91. As discussed above, when the ratio Lₘᵢₙ/Lₐᵥₑ satisfies the above range, damage to the gas barrier layer during manufacture can be reduced, and thus a photoelectric conversion element 10 with a high gas barrier property can be achieved. Thus, the durability of the photoelectric conversion element 10 can be further enhanced.

By suppressing the effect of the formation of the first through hole 6 on the gas barrier layer 2, a high gas barrier property can be maintained. For example, in the gas barrier layer 2, it is desirable that a ratio t1/t0 of a film thickness t1 of the gas barrier layer 2 at a site where the gas barrier layer 2 is exposed from the first electrode layer 3 by the first through hole 6 to a film thickness t0 of the gas barrier layer 2 at a site where the gas barrier layer 2 is covered by the first electrode layer 3 should satisfy 0.8 ≤ t1/t0 ≤ 1. When the ratio t1/t0 of the film thicknesses of the gas barrier layer 2 satisfies the above range, a sufficient gas barrier property of the gas barrier layer 2 is maintained. Thus, when the ratio t1/t0 of the film thickness of the gas barrier layer 2 satisfies the above range, a high gas barrier property can be achieved, and thus the durability of the photoelectric conversion element 10 can be further enhanced.

The film thickness t0 and the film thickness T1 of the gas barrier layer 2 can be determined from a cross-sectional SEM image of the photoelectric conversion element 10. Specifically, at a site of the gas barrier layer 2 covered by the first electrode layer 3, the film thickness of the gas barrier layer 2 is measured at any five locations within the range of 1 µm, and the average value of the film thicknesses is defined as t0. Meanwhile, at a site of the gas barrier layer 2 not covered by the first electrode layer 3, the film thickness of the gas barrier layer 2 is measured at any five locations within the range of 1 µm, and the average value of the film thicknesses is defined as t1. However, the film thickness t1 is considered to be 0, since the function of the gas barrier layer 2 is significantly reduced when a through hole or damage such as peeling is found at the site of the gas barrier layer 2 not covered by the first electrode layer 3.

### <Light Absorbing Layer>

The light absorbing layer 4 is provided so as to fill the first through hole 6 and disposed in contact with the first electrode layer 3 and the gas barrier layer 2.

The light absorbing layer 4 contains, for example, a perovskite compound. For a photoelectric conversion element containing a perovskite compound, it is necessary to further reduce gases such as water vapor that intrude into the element from the viewpoint of durability. The photoelectric conversion element 10 according to the first embodiment can prevent gases such as water vapor from intruding into the element as discussed above, and thus can achieve excellent durability even when the light absorbing layer 4 contains a perovskite compound. Thus, it is possible to achieve a flexible photoelectric conversion element 10 that contains a perovskite compound and achieves both high durability and a uniform appearance.

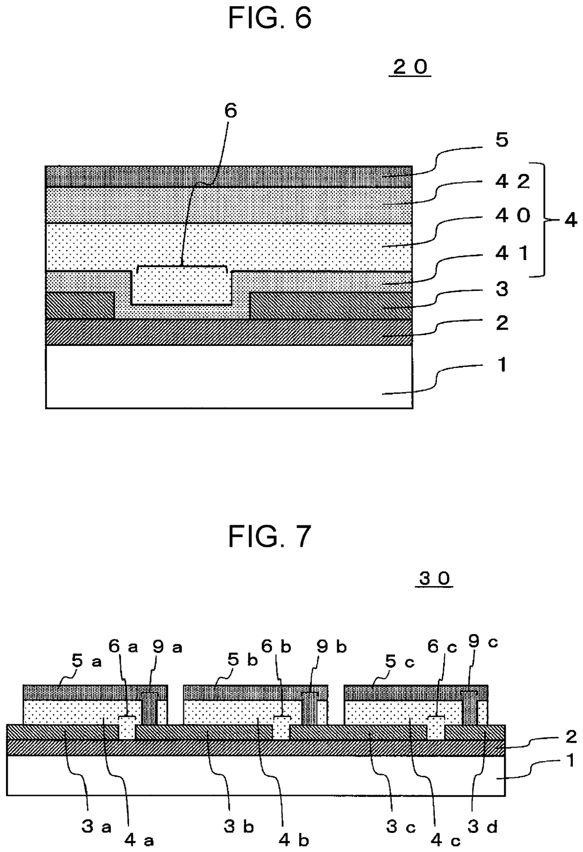

Fig. 6 is a schematic cross-sectional view illustrating a modification of the photoelectric conversion element according to the first embodiment of the present disclosure. As illustrated in Fig. 6, in a photoelectric conversion element 20, which is a modification, the light absorbing layer 4 includes a photoelectric conversion layer 40. In this case, the photoelectric conversion layer 40 may contain a perovskite compound. To manufacture such a photoelectric conversion element 20, the above (C) of the manufacturing method according to the first embodiment includes forming a photoelectric conversion layer 40.

The perovskite compound may be represented by a chemical formula ABX₃. A is a monovalent cation. Examples of the monovalent cation include monovalent cations such as alkali metal cations and organic cations. More specific examples include methylammonium cation (CH₃NH₃⁺), formamidinium cation (HC(NH₂)₂⁺), ethylammonium cation (CH₃CH₂NH₃⁺), guanidinium cation (CH₆N₃⁺), potassium cation (K⁺), cesium cation (Cs⁺), and rubidium cation (RB⁺). B is a divalent cation, examples of which include lead cation (Pb²⁺) and tin cation (Sn²⁺). X is a monovalent anion, such as halogen anion. Each site of A, B, and X may be occupied by a plurality of kinds of ions.

The thickness of the photoelectric conversion layer 40 is 50 nm or more and 10 µm or less, for example. The photoelectric conversion layer 40 can be formed using a solution coating method, a printing method, a vapor deposition method, etc. The photoelectric conversion layer 40 may be formed by cutting a perovskite compound.

The photoelectric conversion layer 40 may mainly contain a perovskite compound represented by the chemical formula ABX₃. Here, the wording "the photoelectric conversion layer 40 mainly contains a perovskite compound represented by the chemical formula ABX₃" means that the photoelectric conversion layer 40 contains 90 mass% or more of a perovskite compound represented by the chemical formula ABX₃. The photoelectric conversion layer 40 may contain 95 mass% or more of a perovskite compound represented by the chemical formula ABX₃. The photoelectric conversion layer 40 may be composed of a perovskite compound represented by the chemical formula ABX₃. It is only necessary that the photoelectric conversion layer 40 should contain a perovskite compound represented by the chemical formula ABX₃, and the photoelectric conversion layer 40 may contain defects or impurities.

The photoelectric conversion layer 40 may further contain other compounds different from a perovskite compound represented by the chemical formula ABX₃. Examples of the other, different compounds include a compound with a Ruddlesden-Popper type layered perovskite structure.

As illustrated in Fig. 6, the light absorbing layer 4 may include an electron transport layer 41. In that case, the electron transport layer 41 is positioned between the photoelectric conversion layer 40 and the first electrode layer 3, or between the photoelectric conversion layer 40 and the second electrode layer 5. Fig. 6 illustrates an example in which the electron transport layer 41 is disposed between the photoelectric conversion layer 40 and the first electrode layer 3.

The electron transport layer 41 contains a semiconductor. The electron transport layer 41 may be a semiconductor with a bandgap of 3.0 eV or more. By forming the electron transport layer 41 from a semiconductor with a bandgap of 3.0 eV or more, visible light and infrared light can be transmitted to the photoelectric conversion layer 40. Examples of the semiconductor include an inorganic n-type semiconductor.

Examples of the inorganic n-type semiconductor include oxides of metal elements, nitrides of metal elements, and perovskite-type oxides. Examples of the oxides of metal elements include oxides of Cd, Zn, In, Pb, Mo, W, Sb, Bi, Cu, Hg, Ti, Ag, Mn, Fe, V, Sn, Zr, Sr, Ga, Si, and Cr. More specific examples include TiO₂ and SnO₂. Example of the nitrides of metal elements include GaN. Examples of the perovskite-type oxides include SrTiO₃ and CaTiO₃. In addition, the electron transport layer 41 may include a plurality of layers composed of materials different from each other.

As illustrated in Fig. 6, the light absorbing layer 4 may include a hole transport layer 42. In that case, the hole transport layer 42 is positioned between the photoelectric conversion layer 40 and the first electrode layer 3, or between the photoelectric conversion layer 40 and the second electrode layer 5. Fig. 6 illustrates an example in which the hole transport layer 42 is disposed between the photoelectric conversion layer 40 and the second electrode layer 5.

The hole transport layer 42 contains a hole transport material. The hole transport material is a material that transports holes. The hole transport layer 42 is composed of a hole transport material such as an organic material or an inorganic semiconductor.

Typical examples of the organic material to be used as the hole transport material include 2,2',7,7'-tetrakis-(N,N-di-p-methoxyphenylaₘᵢₙe)9,9'-spirobifluorene, poly[bis(4-phenyl)(2,4,6-trimethylphenyl)aₘᵢₙe] (hereinafter occasionally abbreviated as "PTAA"), poly(3-hexylthiophene-2,5-diyl), poly(3,4-ethylenedioxythiophene), and copper phthalocyanine.

The inorganic semiconductor to be used as the hole transport material is a p-type semiconductor. Examples of the inorganic semiconductor include carbon materials such as Cu₂O, CuGaO₂, CuSCN, CuI, NiOₓ, MoOₓ, V₂O₅, and graphene oxide. In addition, the hole transport layer 42 may include a plurality of layers composed of materials different from each other.

As illustrated in Fig. 6, the light absorbing layer 4 may include an electron transport layer 41, a photoelectric conversion layer 40 containing a perovskite compound, and a hole transport layer 42. With this configuration, the photoelectric conversion element 20 may be a flexible photoelectric conversion element that contains a perovskite compound and achieves both high durability and a uniform appearance, and that can provide a further improved photoelectric conversion efficiency. To manufacture a photoelectric conversion element 20 with such a configuration, the above (C) of the manufacturing method according to the first embodiment includes forming an electron transport layer 41, forming a photoelectric conversion layer 40, and forming a hole transport layer 42.

### <Second Electrode Layer>

The second electrode layer 5 is electrically conductive. The second electrode layer 5 may use the same material as the first electrode layer 3. The second electrode layer 5 may also use a metallic material. The thickness of the second electrode layer 5 is 1 nm or more and 1000 nm or less, for example.

### (Second Embodiment)

Fig. 7 is a schematic cross-sectional view illustrating a photoelectric conversion module as a photoelectric conversion element according to a second embodiment of the present disclosure.

The photoelectric conversion element according to the second embodiment is a photoelectric conversion module 30 in which a plurality of cells are connected. Fig. 7 illustrates a structure in which three cells are connected in series, by way of example. In the photoelectric conversion module 30 illustrated in Fig. 7, the light absorbing layer 4 and the second electrode layer 5 are divided into three cells at positions different from the first through hole 6, and each cell of the light absorbing layer 4a, 4b, and 4c has a first through hole 6a, 6b, and 6c and a second through hole 9a, 9b, and 9c provided at different positions. The second electrode layer 5a, 5b, and 5c is connected to the first electrode layer of an adjacent cell through the second through hole 9a, 9b, and 9c, respectively. This allows the plurality of cells to be connected in series. Here, the formation of the second through holes 9a, 9b, 9c and the division of the cells can be performed by, but not limited to, processing with a pulsed laser.

The photoelectric conversion element according to the second embodiment can provide a photoelectric conversion module 30 that achieves both high durability and a uniform appearance.

### [Other Embodiments]

### (Appendix)

The above description of the embodiments discloses the following technologies.

### (Technology 1)

A photoelectric conversion element manufacturing method including:
(A) forming a first electrode layer on a gas barrier layer;
(B) removing a part of the first electrode layer using a pulsed laser to form a plurality of through holes so as to penetrate the first electrode layer and partially overlap each other;
(C) forming a light absorbing layer on the first electrode layer and on the gas barrier layer exposed by the through hole; and
(D) forming a second electrode layer on the light absorbing layer.
With the manufacturing method according to technology 1, it is possible to manufacture a photoelectric conversion element that achieves both high durability and a uniform appearance.

### (Technology 2)

The photoelectric conversion element manufacturing method according to technology 1, in which

### the pulsed laser has a pulse width of less than 1 ns.

### (Technology 3)

The photoelectric conversion element manufacturing method according to technology 1 or 2, in which
a ratio t1/t0 of a film thickness t1 of the gas barrier layer at a site where the gas barrier layer is exposed from the first electrode layer by the through hole to a film thickness t0 of the gas barrier layer at a site where the gas barrier layer is covered by the first electrode layer satisfies 0.8 ≤ t1/t0 ≤ 1.

### (Technology 4)

The photoelectric conversion element manufacturing method according to technology 1 or 2, in which
the through hole is formed such that an average value Lₐᵥₑ of line width L of the through hole is less than 100 µm.

### (Technology 5)

The photoelectric conversion element manufacturing method according to technology 1 or 2, in which
in the (B), line width L of the through hole is continuously varied by radiating the pulsed laser onto the first electrode layer such that a ratio Lₘᵢₙ/Lₐᵥₑ of a minimum value Lₘᵢₙ of the line width L of the through hole to an average value Lₐᵥₑ of the line width L satisfies 0.57 < Lₘᵢₙ/Lₐᵥₑ < 0.91.

In processing with a pulsed laser, a circular through hole is usually formed for each pulse. In order to form a linear through hole in the first electrode layer using a pulsed laser, circular through holes formed for each pulse are continuously formed. In that event, the damage to the gas barrier layer caused by the irradiation with the pulsed laser can be reduced by reducing the overlap between pulses. With the manufacturing method according to the technology 2, by radiating a pulsed laser onto the first electrode layer such that the ratio Lₘᵢₙ/Lₐᵥₑ satisfies 0.57 < Lₘᵢₙ/Lₐᵥₑ < 0.91, a linear through hole can be formed while further reducing the damage to the gas barrier layer.

### (Technology 6)

The photoelectric conversion element manufacturing method according to technology 1 or 2, in which
in the (A), the gas barrier layer is provided on a first principal surface of a base material containing an organic material.

### (Technology 7)

The photoelectric conversion element manufacturing method according to technology 1 or 2, in which
in the (A), the gas barrier layer is formed above a second photoelectric conversion element.

### (Technology 8)

The photoelectric conversion element manufacturing method according to technology 1 or 2, in which
the light absorbing layer includes a photoelectric conversion layer containing a perovskite compound, and
the (C) includes forming the photoelectric conversion layer.

For a photoelectric conversion element containing a perovskite compound, it is necessary to further reduce gases such as water vapor that intrude into the element from the viewpoint of durability. The photoelectric conversion element manufactured by the manufacturing method according to technology 8, in which the light absorbing layer contains a perovskite compound, can prevent gases such as water vapor from intruding into the element, and thus can achieve excellent durability.

### (Technology 9)

The photoelectric conversion element manufacturing method according to technology 1 or 2, in which
the light absorbing layer includes an electron transport layer, a photoelectric conversion layer containing a perovskite compound, and a hole transport layer, and
the (C) includes forming the electron transport layer, forming the photoelectric conversion layer, and forming the hole transport layer.

With the manufacturing method according to technology 9, it is possible to manufacture a photoelectric conversion element that achieves both high durability and a uniform appearance, and that contains a perovskite compound and can provide a further improved photoelectric conversion efficiency.

### (Technology 10)

A photoelectric conversion element including:
a gas barrier layer;
a first electrode layer disposed on the gas barrier layer and having a first through hole including a plurality of holes partially overlapping each other;
a light absorbing layer disposed on the first electrode layer and on the gas barrier layer exposed by the first through hole; and
a second electrode layer disposed on the light absorbing layer.

### (Technology 11)

The photoelectric conversion element according to technology 10, in which
a ratio t1/t0 of a film thickness t1 of the gas barrier layer at a site where the gas barrier layer is exposed from the first electrode layer by the first through hole to a film thickness t0 of the gas barrier layer at a site where the gas barrier layer is covered by the first electrode layer satisfies 0.8 ≤ t1/t0 ≤ 1.

With this configuration, a high gas barrier property can be achieved, and thus the durability of the photoelectric conversion element can be further enhanced.

### (Technology 12)

The photoelectric conversion element according to technology 10, in which
an average value Lₐᵥₑ of line width L of the first through hole is less than 100 µm.

### (Technology 13)

The photoelectric conversion element according to technology 10, in which
line width L of the first through hole varies continuously, and
a ratio Lₘᵢₙ/Lₐᵥₑ of a minimum value Lₘᵢₙ of the line width L to an average value Lₐᵥₑ of the line width L satisfies 0.57 < Lₘᵢₙ/Lₐᵥₑ < 0.91.

With this configuration, damage to the gas barrier layer during manufacture can be reduced, and thus a photoelectric conversion element with a high gas barrier property can be achieved. Thus, the durability of the photoelectric conversion element can be further enhanced.

### (Technology 14)

The photoelectric conversion element according to technology 10, in which
the gas barrier layer is provided on a first principal surface of a base material containing an organic material.

### (Technology 15)

The photoelectric conversion element according to claim 10, further including
a second photoelectric conversion element, wherein
the gas barrier layer is disposed above the second photoelectric conversion element.

### (Technology 16)

The photoelectric conversion element according to technology 14, in which
a water vapor transmission rate of a stacked body formed from the base material, the gas barrier layer, and the first electrode layer as measured under conditions of a temperature of 85°C and a relative humidity of 85% is less than 1 × 10⁰ g/m²/day.

With this configuration, it is possible to provide a photoelectric conversion element that achieves both high durability and a uniform appearance.

### (Technology 17)

The photoelectric conversion element according to technology 10, in which
the light absorbing layer contains a perovskite compound.

With this configuration, it is possible to provide a photoelectric conversion element that contains a perovskite compound and achieves both high durability and a uniform appearance.

### (Technology 18)

The photoelectric conversion element according to technology 10, in which
the light absorbing layer includes an electron transport layer, a photoelectric conversion layer containing a perovskite compound, and a hole transport layer.

With this configuration, it is possible to provide a photoelectric conversion element that contains a perovskite compound and achieves both high durability and a uniform appearance, and that can provide a further improved photoelectric conversion efficiency.

### (Technology 19)

The photoelectric conversion element according to technology 10, in which
the light absorbing layer and the second electrode layer are divided into a plurality of cells at a position different from the first through hole,
the light absorbing layer of each of the plurality of cells has a second through hole provided at a position different from the first through hole,
the second electrode layer is connected to the first electrode layer of an adjacent cell via the second through hole, and
the plurality of cells are connected in series with each other.

With this configuration, it is possible to provide a photoelectric conversion module in which a plurality of cells are integrated and which achieves both high durability and a uniform appearance.

### Examples

Examples of the present disclosure will be described below. However, the present disclosure is not limited to the following examples.

### [Example 1]

First, a PET film was prepared; on its principal surface, an indium-tin composite oxide layer as the gas barrier layer 2 and the first electrode layer 3 were provided. In the present example, a PET film with a thickness of 75 µm was used as the base material 1.

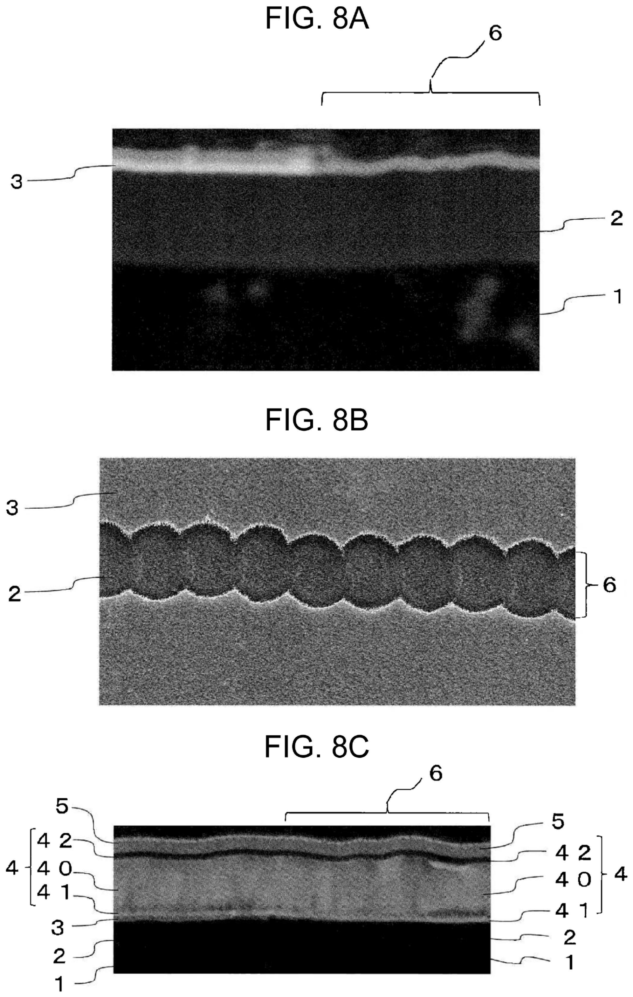

Next, the first through hole 6 was formed by removing the first electrode layer 3 using a picosecond pulsed laser with a pulse width of 2 ps, a repetition frequency of 50 kHz, and a wavelength of 532 nm. The laser power was 80 mW. The average value Lₐᵥₑ of the line width L of the first through hole 6 was 10 µm. Fig. 8A is an SEM image of a partial cross section of the photoelectric conversion element according to Example 1. Fig. 8B is a partial top SEM image obtained by capturing a part of the first electrode layer in which the through hole 6 is formed from the top of Example 1. In the portion of the first electrode layer 3 in which the through hole 6 is formed, the gas barrier layer 2 below the removed portion is exposed and visible. The average value Lₐᵥₑ of the line width L of the first through hole 6 was determined using Fig. 8B.

Next, an SnO₂ layer was formed as the electron transport layer 41 on the first electrode layer 3 by a spin coating method. The thickness of the SnO₂ layer was 30 nm.

Next, the photoelectric conversion layer 40 containing a perovskite compound was formed by applying a raw material solution of a photoelectric conversion material by spin coating. A solution containing lead(II) iodide (manufactured by Tokyo Chemical Industry), lead(II) bromide (manufactured by Tokyo Chemical Industry), formamidinium iodide (manufactured by GreatCell Solar), and methylammonium iodide (manufactured by GreatCell Solar) was used as the raw material solution. A mixture of dimethyl sulfoxide (manufactured by Acros) and N,N-dimethylformamide (manufactured by Acros) was used as the solvent of the solution. The mixing ratio (DMSO:DMF) of dimethyl sulfoxide (DMSO) and N,N-dimethylformamide (DMF) in the raw material solution was 1:8 by volume.

Next, the hole transport layer 42 containing PTAA was formed on the photoelectric conversion layer 40 by applying a raw material solution of a hole transport material by a spin coating method. Toluene (manufactured of Acros) was used as the solvent of the raw material solution, and the solution contained 10 g/L of PTAA.

Next, the second electrode layer 5 was formed on the hole transport layer 42 by forming an indium-tin composite oxide film by a sputtering method. In this way, the photoelectric conversion element according to Example 1 was obtained. Fig. 8C is a cross-sectional SEM image of the photoelectric conversion element according to Example 1. As illustrated in Fig. 8C, the photoelectric conversion element fabricated in Example 1 had the same structure as the photoelectric conversion element 20 described in the first embodiment. In more detail, in the SEM image illustrated in Fig. 8C, the right area of the SEM image is the portion of the photoelectric conversion element according to Example 1 in which the first through hole 6 is formed. As can be seen from the SEM image, the substrate 1, the gas barrier layer 2, the electron transport layer 41, the photoelectric conversion layer 40, the hole transport layer 42, and the second electrode layer 5 are stacked in that order in the portion of the photoelectric conversion element according to Example 1 in which the first through hole 6 is formed. On the other hand, the substrate 1, the gas barrier layer 2, the first electrode layer 3, the electron transport layer 41, the photoelectric conversion layer 40, the hole transport layer 42, and the second electrode layer 5 are stacked in this order in the portion of the photoelectric conversion element according to Example 1 in which the first through hole 6 is not formed (that is, the left area of the SEM image).

### [Example 2]

In Example 2, the laser power for the formation of the first through hole 6 was 80 mW, and the first through hole 6 was formed by irradiating the same location with laser twice. Besides that, the photoelectric conversion element according to Example 2 was obtained in the same manner as in Example 1.

### [Comparative Example 1]

In Comparative Example 1, a nanosecond laser was used as the laser for the formation of the first through hole 6. The pulse width was 10 ns and the wavelength was 355 nm. Besides that, the photoelectric conversion element according to Comparative Example 1 was obtained in the same manner as in Example 1.

### [Comparative Example 2]

In Comparative Example 2, a mask sputtering method was used for the formation of the first through hole 6. When forming the first electrode layer on the gas barrier layer, the first electrode layer 3 with the first through hole 6 was formed by sputtering an indium-tin composite oxide using a mask. Besides that, the photoelectric conversion element according to Comparative Example 2 was obtained in the same manner as in Example 1.

### < Evaluation of Fabricated Photoelectric Conversion Element>

### (Water Vapor Transmission Rate (WVTR))

The water vapor transmission rate of a stacked body formed from the base material 1, the gas barrier layer 2, and the first electrode layer 3 having the through hole 6 was measured under the conditions of a temperature of 85°C and a relative humidity of 85%. Specifically, the water vapor transmission rate was measured using the calcium corrosion method discussed above. The results are indicated in Table 1. Furthermore, durability tests of perovskite solar cells were conducted using the stacked bodies according to Example 1, Example 2, and Comparative Example 1 for which a water vapor transmission rate had been measured. A perovskite solar cell was placed on a glass substrate, and the perovskite solar cell was covered by a stacked body formed from the base material 1, the gas barrier layer 2, and the first electrode layer 3 having the through hole 6. The appearance of the perovskite solar cell was visually observed after the lapse of 200 hours under the conditions of a temperature of 85°C and a relative humidity of 85%. The appearance of the perovskite solar cell was maintained when the stacked bodies according to Examples 1 and 2, whose water vapor transmission rate was less than 1 × 10⁰ (g/m²/day), were used. However, decolorization of the perovskite solar cell was found when the stacked body according to Comparative Example 1, whose water vapor transmission rate was not less than 1 × 10⁰ (g/m²/day), was used.

### (Average Value Lₐᵥₑ of Line Width L of First Through Hole)

The average value Lₐᵥₑ of the line width L of the first through hole 6 was determined using an SEM image viewed from the top surface of the first electrode layer 3 in which the first through hole 6 was formed. Specifically, in the SEM image viewed from the top surface of the first electrode layer 3 in which the first through hole 6 was formed, the area of a portion from which the first electrode layer 3 had been removed (i.e., the portion of the linear through hole 6) and the length of such a portion (i.e., the length along the direction in which the linear through hole 6 extends) were determined. Next, a rectangle having the same area as the determined area and the same length as the determined length of the linear first through hole 6 was determined. The width (the length of the short side) of the rectangle was defined as the average value Lₐᵥₑ of the line width L of the first through hole 6. The results are indicated in Table 1.

### (Appearance)

The uniformity of the appearance of the fabricated photoelectric conversion element was visually checked. In Table 1, A is given when uniformity was maintained, and B is given when uniformity was not maintained.

### (Evaluation of Gas Barrier Property)

The gas barrier property was evaluated on the basis of the WVTR value. The gas barrier property was determined to be sufficient when the WVTR was less than 1 × 10⁰ (g/m²/day). In Table 1, A is given when the gas barrier property was sufficient, and B is given when the gas barrier property was insufficient.

**[Table 1]**

| | Method of fabricating through hole | Laser power (mW) | Laser pulse width | WVTR (g/m²/day) | Average value Lₐᵥₑ of Line width L (µm) | Appearance | Gas barrier property |
|---|---|---|---|---|---|---|---|
| Example 1 | Picosecond laser | 80 | 2 ps | 1 × 10⁻³ | 12 | A | A |
| Example 2 | Picosecond laser | 80 × 2 | 2 ps | 1 × 10⁻¹ | 12 | A | A |
| Comparative Example 1 | Nanosecond laser | 80 | 10 ns | > 1 × 10⁰ | 40 | A | B |
| Comparative Example 2 | Mask sputtering | - | - | 1 × 10⁻³ | 100 | B | A |

As is clear from Table 1, the gas barrier property was reduced in Comparative Example 1. This is because there was no barrier layer in at least a part of the through hole portion, the WVTR value was high compared to Examples 1 and 2. Furthermore, it was clear that in Comparative Example 2, the average value Lₐᵥₑ of the line width L of the first through hole 6 was large, and the uniformity of the appearance was impaired. On the other hand, in Examples 1 and 2, both a gas barrier property and a uniform appearance were achieved by fabricating the first through hole using a laser with a pulse width of less than 1 ns.

In the manufacturing methods according to the first embodiment, the second embodiment, and the other embodiments, a second photoelectric conversion element may be further formed above the base material, and the gas barrier layer may be disposed above the second photoelectric conversion element, constituting a tandem structure.

When the second photoelectric conversion element is included, the second photoelectric conversion element may include a light absorbing layer, the light absorbing layer may include a photoelectric conversion layer, and the photoelectric conversion layer may contain a perovskite compound.

### Industrial Applicability

The photoelectric conversion element according to the present disclosure can achieve both high durability and a uniform appearance, and thus can be said to have extremely high industrial applicability.

### Reference Signs List

1 substrate
2 gas barrier layer
3, 3a, 3b, 3d first electrode layer
4, 4a, 4b, 4c light absorbing layer
40 photoelectric conversion layer
41 electron transport layer
42 hole transport layer
5, 5a, 5b, 5c second electrode layer
6, 6a, 6b, 6c first through hole
61 rectangle
62 circular through hole
9a, 9b, 9c second through hole
10, 20 photoelectric conversion element
30 photoelectric conversion module

## Claims

1. A photoelectric conversion element manufacturing method comprising:
(A) forming a first electrode layer on a gas barrier layer;
(B) removing a part of the first electrode layer using a pulsed laser to form a through hole penetrating the first electrode layer and including a plurality of holes partially overlapping each other;
(C) forming a light absorbing layer on the first electrode layer and on the gas barrier layer exposed by the through hole; and
(D) forming a second electrode layer on the light absorbing layer.

2. The photoelectric conversion element manufacturing method according to claim 1, wherein
the pulsed laser has a pulse width of less than 1 ns.

3. The photoelectric conversion element manufacturing method according to claim 1 or 2, wherein
a ratio t1/t0 of a film thickness t1 of the gas barrier layer at a site where the gas barrier layer is exposed from the first electrode layer by the through hole to a film thickness t0 of the gas barrier layer at a site where the gas barrier layer is covered by the first electrode layer satisfies 0.8 ≤ t1/t0 ≤ 1.

4. The photoelectric conversion element manufacturing method according to claim 1 or 2, wherein
the through hole is formed such that an average value Lₐᵥₑ of line width L of the through hole is less than 100 µm.

5. The photoelectric conversion element manufacturing method according to claim 1 or 2, wherein
in the (B), line width L of the through hole is continuously varied by radiating the pulsed laser onto the first electrode layer such that a ratio Lₘᵢₙ/Lₐᵥₑ of a minimum value Lₘᵢₙ of the line width L of the through hole to an average value Lₐᵥₑ of the line width L satisfies 0.57 < Lₘᵢₙ/Lₐᵥₑ < 0.91.

6. The photoelectric conversion element manufacturing method according to claim 1 or 2, wherein
in the (A), the gas barrier layer is provided on a first principal surface of a base material containing an organic material.

7. The photoelectric conversion element manufacturing method according to claim 1 or 2, wherein
in the (A), the gas barrier layer is formed above a second photoelectric conversion element.

8. The photoelectric conversion element manufacturing method according to claim 1 or 2, wherein
the light absorbing layer includes a photoelectric conversion layer containing a perovskite compound, and
the (C) includes forming the photoelectric conversion layer.

9. The photoelectric conversion element manufacturing method according to claim 1 or 2, wherein
the light absorbing layer includes an electron transport layer, a photoelectric conversion layer containing a perovskite compound, and a hole transport layer, and
the (C) includes forming the electron transport layer, forming the photoelectric conversion layer, and forming the hole transport layer.

10. A photoelectric conversion element comprising:
a gas barrier layer;
a first electrode layer disposed on the gas barrier layer and having a first through hole including a plurality of holes partially overlapping each other;
a light absorbing layer disposed on the first electrode layer and on the gas barrier layer exposed by the first through hole; and
a second electrode layer disposed on the light absorbing layer.

11. The photoelectric conversion element according to claim 10, wherein
a ratio t1/t0 of a film thickness t1 of the gas barrier layer at a site where the gas barrier layer is exposed from the first electrode layer by the first through hole to a film thickness t0 of the gas barrier layer at a site where the gas barrier layer is covered by the first electrode layer satisfies 0.8 ≤ t1/t0 ≤ 1.

12. The photoelectric conversion element according to claim 10, wherein
an average value Lₐᵥₑ of line width L of the first through hole is less than 100 µm.

13. The photoelectric conversion element according to claim 10, wherein
line width L of the first through hole varies continuously, and
a ratio Lₘᵢₙ/Lₐᵥₑ of a minimum value Lₘᵢₙ of the line width L to an average value Lₐᵥₑ of the line width L satisfies 0.57 < Lₘᵢₙ/Lₐᵥₑ < 0.91.

14. The photoelectric conversion element according to claim 10, wherein
the gas barrier layer is provided on a first main surface of a base material containing an organic material.

15. The photoelectric conversion element according to claim 10, further comprising:
a second photoelectric conversion element, wherein
the gas barrier layer is disposed above the second photoelectric conversion element.

16. The photoelectric conversion element according to claim 14, wherein
a water vapor transmission rate of a stacked body formed from the base material, the gas barrier layer, and the first electrode layer as measured under conditions of a temperature of 85°C and a relative humidity of 85% is less than 1 × 10⁰ g/m²/day.

17. The photoelectric conversion element according to claim 10, wherein
the light absorbing layer contains a perovskite compound.

18. The photoelectric conversion element according to claim 10, wherein
the light absorbing layer includes an electron transport layer, a photoelectric conversion layer containing a perovskite compound, and a hole transport layer.

19. The photoelectric conversion element according to claim 10, wherein
the light absorbing layer and the second electrode layer are divided into a plurality of cells at a position different from the first through hole,
the light absorbing layer of each of the plurality of cells has a second through hole provided at a position different from the first through hole,
the second electrode layer is connected to the first electrode layer of an adjacent cell via the second through hole, and
the plurality of cells are connected in series with each other.
